# NEUE EUROPÄISCHE PATENTSCHRIFT

(11) **EP 2 127 800 B2**
(45) Veröffentlichungstag und Bekanntmachung des Hinweises auf die Entscheidung über den Einspruch: **30.11.2016**
(45) Hinweis auf die Patenterteilung: 09.01.2013
(21) Anmeldenummer: 09006994.9
(22) Anmeldetag: 26.05.2009
(51) Int. Cl.: B23K 37/04, B25B 11/00, H05K 3/00, H05K 13/00

(54) **Leiterplattentrenneneirichtung**
Circuit board partition device
Dispositif de séparation de plaquettes

(30) Priorität: 30.05.2008 DE 102008027138
(43) Veröffentlichungstag der Anmeldung: 02.12.2009
(73) Patentinhaber: SCHUNK Electronic Solutions GmbH, 78112 St. Georgen (DE)
(72) Erfinder: Lorenz, Stefan, 91338 Igensdorf (DE); Rosenfelder, Frank, 78112 St. Georgen (DE); Heilmann, Matthias, 78126 Königsfeld (DE); Goedecke, Wolf-Dieter, 78112 St. Georgen (DE)
(74) Vertreter: DREISS Patentanwälte PartG mbB

(56) Entgegenhaltungen:
- US-A- 4 947 980
- US-A1- 2005 269 302
- US-A1- 2008 066 596
- US-B1- 6 394 519
- US-B1- 6 644 637

## Beschreibung

Die Erfindung betrifft eine Leiterplattentrenneinrichtung zum Vereinzeln von insbesondere bestückten Leiterplatten aus einem Leiterplattensubstrat, mit einer mechanisch, insbesondere fräsend oder sägend wirkenden oder laserbasierten numerisch steuerbaren Trennvorrichtung und mit einem Werkstückträger, wobei das Leiterplattensubstrat und die hieraus im Zuge der Trennbearbeitung vereinzelten Leiterplatten während der Trennbearbeitung auf dem Werkstückträger gehalten ist/sind. Aus der US 2008/0066596 A1 ist eine Plasma- oder Laserschneideinrichtung bekannt. Eine weitere Leiterplattentrenneinrichtung ist bekannt aus DE 20 2005 021 343 U1.

Bei bekannten Leiterplattentrenneinrichtungen wird der Werkstückträger zumeist für eine spezifische Anwendung, das heißt zum Trennen eines bestimmten Leiterplattensubstrats entsprechend dessen jeweiliger Geometrie und dem Trennmuster konstruiert, indem geeignete Halte- oder Stützelemente entsprechend der auszuführenden Trennbearbeitung auf einer Grundbasis angeordnet und mechanisch fixiert werden. Die Konstruktion eines solchen Werkstückträgers ist zum einen aufwändig und erweist sich außerdem als nachteilig, weil der Werkstückträger ja nur für das spezifische flächenhafte Werkstück konzipiert ist und somit nicht für andere Werkstücke benutzt werden kann.

Aus der US 6,644,637 B1 ist ein Werkstückträger zur Befestigung eines Werkstücks in Form eines Zylinderkopfs bekannt. Die Positionierung des Zylinderkopfs an dem Werkstückträger erfolgt durch Positioniersäulen, welche unter Zwischenschaltung einer Führungsschiene mechanisch mit dem Werkstückträger verbunden sind.

Der vorliegenden Erfindung liegt die Aufgabe zugrunde, eine Leiterplattentrenneinrichtung der genannten Art bereit zu stellen, die wirtschaftlicher benutzbar ist.

Diese Aufgabe wird bei einer Leiterplattentrenneinrichtung erfindungsgemäß mit den Merkmalen des Patentanspruchs 1 gelöst.

Die Anordnung von Halte- oder Stützelementen unter Einsatz magnetischer Haftkräfte gestattet es, den Werkstückträger auf einfachere und vor allem kostengünstigere Weise zu konzipieren und herzustellen, und zwar auch für Kleinserien von Leiterplatten. Nach Ausführung der Trennbearbeitung beispielsweise einer Kleinserie kann nämlich der Werkstückträger ohne aufwändige Bearbeitungsschritte zu erfordern, für eine andere Bearbeitungsaufgabe weiter verwendet werden. Die nur magnetisch haftenden Halte- oder Stützelemente brauchen lediglich entfernt und nach einem neuen Bestückungsprogramm erneut angeordnet zu werden. Dies erweist sich als besonders wirtschaftlich, zumal hierfür automatisierte, numerisch gesteuerte Prozesse eingesetzt werden können.

Der Werkstückträger der erfindungsgemäßen Leiterplattentrenneinrichtung lässt sich insbesondere ohne mechanische Montagemaßnahmen zu erfordern unter Einsatz einfacher "Pick- and Place"-Operationen konfigurieren, was sich als besonders vorteilhaft erweist.

Die erwähnten Halte- oder Stützelemente können grundsätzlich in an sich beliebiger Weise ausgebildet sein. Es erweist sich indessen als vorteilhaft, wenn die Halte- oder Stützelemente werkstückzugewandt einen stiftförmigen, insbesondere im wesentlichen zylindrischen Abschnitt aufweisen, da solchenfalls eine den Anforderungen entsprechende optimale Anordnung möglich ist, ohne dass sich die Halte- oder Stützelemente gegenseitig behindern. Dabei erweist es sich als vorteilhaft, wenn der stiftförmige Abschnitt einen Durchmesser oder eine Querschnittskantenlänge in der Werkstückebene oder parallel zur Werkstückebene von 1 - 10 mm, insbesondere von 4 - 10 mm, insbesondere von 4 - 8 mm, aufweist. Die Halte- oder Stützelemente haben eine Längserstreckung senkrecht zur Grundbasis von insbesondere 5 - 120 mm, insbesondere 5 - 100 mm, insbesondere 5 - 80 mm, insbesondere 5 - 60 mm und weiter insbesondere 5 - 50 mm.

Vorzugsweise werden unter anderem Halte- oder Stützelemente verwendet, die werkstückzugewandt eine ebene Auflage- oder Stützfläche für das Werkstück aufweisen. Somit ist eine definierte Positionierung des Werkstücks erreichbar.

Die Halte- oder Stützelemente weisen werkstückzugewandt ein verjüngtes Eingriffs- oder Zentriermittel auf, mittels dessen sie in Eingriffs- oder Zentrierausnehmungen des Leiterplattensubstrats eingreifen können. Somit ist eine wohl definierte Anordnung und Positionierung des Leiterplattensubstrats auf dem Werkstückträger erreichbar.

Ungeachtet der Ausbildung eines Kontaktbereichs der Halte- oder Stützelemente zum Werkstück hin, können die Halte- oder Stützelemente einen hiervon geometrisch und konstruktionstechnisch losgelösten mit der Grundbasis magnetisch zusammenwirkenden Fußabschnitt aufweisen. Dieser Fußabschnitt kann beispielsweise von einem Permanentmagneten gebildet sein, oder ein Permanentmagnet kann in das Halte- oder Stützelement bzw. in dessen Fußabschnitt integriert sein. Beispielsweise kann das Halte- oder Stützelement oder dessen Fußabschnitt auf der vom Werkstück abgewandten Stirnseite eine Ausnehmung aufweisen, in die ein Permanentmagnet eingelassen ist.

Weiter erweist es sich als vorteilhaft, wenn der erwähnte Fußabschnitt eine größere Abmessung parallel zur Werkstückebene als ein werkstückzugewandter Abschnitt der Halte- oder Stützelemente aufweist. Auf diese Weise lässt sich dann eine stärkere Haftkraft zwischen Halte- oder Stützelement und Grundbasis des Werkstückträgers realisieren. Je größer eine magnetisch wirkende Kontaktfläche ist, desto größer ist auch die Haftkraft. Außerdem erweisen sich Kippmomente, die auf die Halte- oder Stützelemente einwirken, als weniger kritisch.

Es erweist sich des weiteren als vorteilhaft, wenn der Werkstückträger eine Mehrzahl von Halte- oder Stützelementen mit Fußabschnitten unterschiedlicher Abmessungen aufweist. Insofern kann den Gegebenheiten entsprechend beispielsweise zwischen kleinen, mittleren und großen Halte- oder Haftkräften unterschieden werden. Naturgemäß führt die Verwendung von Halte- oder Stützelementen mit größeren Fußabschnitten und demgemäß größerer magnetischer Haftfläche zwar zu größeren Haltekräften, jedoch können weniger Halte- oder Stützelemente pro Flächeneinheit auf dem Werkstückträger untergebracht werden.

Die Halte- oder Stützelemente können weiter in vorteilhafter Weise eine Schutzkappe aufweisen, mittels derer sie gegen die Grundbasis anlegbar sind.

Die Grundbasis, bei der es sich nach einer bevorzugten Ausführungsform um eine ebene Grundplatte handelt, ist vorzugsweise aus Eisen gebildet oder sie umfasst ein eisenhaltiges und/oder magnetisches oder magnetisierbares Material. Die Grundbasis kann dabei auch nur bereichsweise magnetisch oder magnetisierbar ausgebildet sein.

Die Grundbasis weist bevorzugtermaßen eine im wesentlichen ebene Oberfläche auf, gegen welche die Halte- oder Stützelemente mit insbesondere ebenen Anlageflächen anliegen und magnetisch fixierbar sind. Dies ist zwar wünschenswert, jedoch nicht zwingend erforderlich. Es wäre auch denkbar, dass die Grundplatte ein vorgegebenes Raster von Anlagepositionen für die Halte- oder Stützelemente aufweist, was jedoch wiederum die Gestaltungsfreiheit einschränkt.

Erfindungsgemäß umfasst der Werkstückträger eine magazinartige Aufnahme für eine Mehrzahl von Halte- oder Stützelementen. Die mehreren Halte- oder Stützelemente sind demnach am Werkstückträger selbst angeordnet, auch wenn sie sich gerade nicht in einer aktiven, das Werkstück tragenden oder stützenden Position befinden. Dennoch sind sie auf diese Weise verfügbar, und der Transportweg von der magazinartigen Aufnahme zu einer Bestückposition am Werkstückträger bzw. umgekehrt ist sehr kurz.

Es erweist sich nach einem weiteren Erfindungsgedanken als besonders vorteilhaft, wenn die magazinartige Aufnahme entlang wenigstens einer, vorzugsweise entlang mehrerer Randseiten des Werkstückträgers erstreckt ist. Die magazinartige Aufnahme kann dabei auf der Grundbasis angeordnet sein. Hierbei ist es denkbar, dass die magazinartige Aufnahme von einem separaten Teil, insbesondere mit einer Mehrzahl von Aufnahmeöffnungen für die jeweiligen Halte- oder Stützelemente, ausgebildet ist, oder die magazinartige Aufnahme kann beispielsweise auch unmittelbar von der Grundbasis des Werkstückträgers gebildet sein, indem dort beispielsweise eine Mehrzahl von Einstecköffnungen für die Halte- oder Stützelemente ausgebildet ist.

Des weiteren kann es sich als vorteilhaft erweisen, wenn Halte- oder Stützelemente in Form von Seitenanschlagmitteln zum Referenzieren des Werkstücks am Werkstückträger vorgesehen sind. Diese Seitenanschlagmittel könnten im einfachsten Fall seitlich gegen einen Rand des Werkstücks anliegen und diesen dabei in der Ebenenrichtung des Werkstücks stützen. Die Seitenanschlagmittel können entweder ebenfalls magnetisch auf der Grundbasis fixierbar sein, oder sie sind als absolut fester Referenzpunkt mechanisch auf der Grundplatte fixiert oder fixierbar, insbesondere eingepresst oder eingeschraubt, was auch manuell erfolgen kann.

Es erweist sich als vorteilhaft, wenn die Seitenanschlagmittel senkrecht zur Werkstückebene zumindest geringfügig über das Werkstück überstehen und so in der Ebene des Werkstücks von außen seitlich gegen das Werkstück anlegbar sind und dieses über seine gesamte Dicke kontaktieren und stützen.

Nach einer weiteren bevorzugten Ausführungsform der Erfindung sind Seitenanschlagmittel vorgesehen, die eine parallel zur Ebene der Grundbasis erstreckte Abstufung oder schlitzförmige Ausnehmungen aufweisen, in welche ein Rand des flächenhaften Werkstücks eingreifen kann und dadurch das Werkstück in senkrechter Richtung zum Werkstückträger fixierbar bzw. definiert anordenbar ist.

In Weiterbildung der Erfindung von besonderer Bedeutung erweist es sich als vorteilhaft, wenn zum Positionieren des Leiterplattensubstrats wenigstens zwei erste Halte- oder Stützelemente mit einem werkstückzugewandten verjüngten Eingriffs- oder Zentriermittel und mehrere zweite Halte- oder Stützelemente mit einem werkstückzugewandten verjüngten Eingriffs- oder Zentriermittel vorgesehen sind, wobei die Eingriffs- oder Zentriermittel der ersten Halte- oder Stützelemente in Z-Richtung länger vorstehen als die Eingriffs- oder Zentriermittel der zweiten Halte- oder Stützelemente, wobei die ersten Halte- oder Stützelemente einer Vorpositionierung und die zweiten Halte- oder Stützelemente einer schlussendlichen Feinpositionierung dienen. Auf diese Weise lässt sich das Leiterplattensubstrat rasch in seine hochgenaue Endposition bringen. Die ersten Halte- oder Stützelemente mit ihren Eingriffs- oder Zentriermitteln dienen gewissermaßen als Einführ- oder Zentrierhilfe für das Leiterplattensubstrat; insofern ist hierfür eine eher geringe Anzahl von ersten Halte- oder Stützelementen erforderlich, insbesondere nur 2-10 Stück. Nach dieser Vorpositionierung kann das Leiterplattensubstrat ohne weiteres in Eingriff mit den Eingriffs- oder Zentriermitteln der zweiten Halte- oder Stützelemente gebracht werden. Die Eingriffs- oder Zentriermittel dieser zweiten Halte- oder Stützelemente korrespondieren mit hoher Genauigkeit mit exakt gebohrten Ausnehmungen in dem Leiterplattensubstrat.

In diesem Zusammenhang erweist es sich als vorteilhaft, wenn zusätzlich die eingangs erwähnten Seitenanschlagmittel vorgesehen sind. Diese können insbesondere in einem allerersten Schritt der Anordnung des Leiterplattensubstrats auf dem Werkstückträger eine Referenzierung des Leiterplattensubstrats unterstützen. Erst danach kommen dann die vorerwähnten ersten und zweiten Halte- oder Stützelemente mit ihren verschieden langen Eingriffs- oder Zentriermitteln zur Wirkung.

Nach einer weiteren Ausführungsform der Erfindung werden Halte- oder Stützmittel vorgeschlagen, welche einen mit der Grundbasis zusammenwirkenden magnetischen Fußabschnitt aufweisen, gegen den eine Mehrzahl verschiedener mit dem Werkstück zusammenwirkender Abschnitte anfügbar, insbesondere anschraubbar ist. Dies bildet bei einem baukastenartig konzeptionierten Werkstückträger die Möglichkeit, dass unter Verwendung ein- und desselben Fußabschnitts unterschiedliche Halte- oder Stützelemente gebildet werden können.

Nach einer weiteren Ausführungsform der Erfindung wird vorgeschlagen, dass auf einem Fußabschnitt gleichzeitig mehrere Halte- oder Stützelemente angeordnet sind, die somit einen geringeren Abstand voneinander aufweisen als die Abmessung des Fußabschnitts in der Ebene der Grundbasis. Es ist somit möglich, ein Leiterplattensubstrat zur Bildung kleinerer Leiterplatten zu trennen und dennoch jede einzelne kleine Leiterplatte vor und während der Trennbearbeitung zu halten. Der Durchmesser der mehreren Halte- oder Stützelemente ist dabei entsprechend klein bemessen und liegt nur bei einem oder wenigen mm, wobei ihr Abstand A ebenfalls in dieser Größenordnung liegt, vorzugsweise < 10 mm, insbesondere < 8 mm, insbesondere < 6 mm, insbesondere < 5 mm beträgt.

Es erweist sich in Weiterbildung dieses Erfindungsgedankens weiter als vorteilhaft, wenn der Fußabschnitt ein zusätzliches von den mehreren Halte- oder Stützelementen verschiedenes, insbesondere quer zur Ebene der Grundbasis vorstehendes Mittel aufweist, welches zum automatisierten Ergreifen des Fußabschnitts beim Bestücken des Werkzeugträgers dienen kann. Alternativ könnte auch der gesamte Fußabschnitt samt den mehreren Halte- oder Stützelementen umfangsseitig ergriffen und aus der magazinartigen Aufnahme automatisiert entnommen werden.

Die Trennvorrichtung der Leiterplattentrenneinrichtung, mittels derer also die Trennbearbeitung des Leiterplattensubstrats ausführbar ist, wird wie eingangs erwähnt zugleich zum Konfigurieren des Werkstückträgers, das heißt, zum Bestücken der Grundbasis des Werkstückträgers mit Halte- oder Stützelementen und gegebenenfalls mit Seitenanschlagmitteln eingesetzt. Hierfür erweist es sich als vorteilhaft, wenn ein Bestückprogramm für die Entnahme und Positionierung der Halte- oder Stützelemente in eine programmierbare Steuervorrichtung der Leiterplattentrenneinrichtung eingebbar ist. Dabei erweist es sich als höchst bedeutsam, dass sowohl das Bestückprogramm als auch das Programm für die Trennbearbeitung dieselbe Referenzierung umfassen.

Das erwähnte Greifmittel zum Ergreifen und Positionieren der jeweiligen Halte- oder Stützelemente umfasst gemäss der Erfindung eine Hülse, die über ein jeweiliges Halte- oder Stützelement stülpbar ist, wobei das jeweilige Halte- oder Stützelement in der Hülse magnetisch fixierbar ist, so dass es greifbar und handhabbar ist. Hierbei ist die magnetisch wirkende Haltekraft zwischen Halte- oder Stützelement und Greifmittel geringer als die magnetische Haftkraft zwischen Halte- oder Stützelement und Grundbasis des Werkstückträgers, so dass das Greifmittel nach dem Positionieren des Halte- oder Stützelements lediglich wieder wegbewegt werden muss, um die Transportverbindung zu lösen.

Weiter erfindungsgemäss umfasst die Trennvorrichtung ein Spannfutter für ein Werkzeug zur Trennbearbeitung, insbesondere für einen Fräser, in welche das Greifmittel zur Ausführung eines Bestückvorgangs des Werkstückträgers einspannbar ist. Auf diese Weise ist das Greifmittel wie ein Werkzeug in dem Spannfutter anordenbar, was insbesondere auch vollautomatisch, also numerisch gesteuert erfolgen kann.

Die vorliegende Erfindung erfasst weiter ein Verfahren zum zum Betreiben einer Leiterplattentrenneinrichtung mit den Merkmalen der Ansprüche 13 und 14.

Weitere Merkmale, Einzelheiten und Vorteile der Erfindung ergeben sich aus den beigefügten Patentansprüchen und aus der zeichnerischen Darstellung und nachfolgenden Beschreibung einer bevorzugten Ausführungsform des erfindungsgemäßen Werkstückträgers bzw. eines Teils der erfindungsgemäßen Trenneinrichtung. In der Zeichnung zeigt:
- Figur 1: eine perspektivische Ansicht eines Teils einer erfindungsgemäßen Leiterplattentrenneinrichtung;
- Figur 2: eine perspektivische Ansicht des Werkstückträgers der Leiterplattentrenneinrichtung nach Figur 1;
- Figur 3: eine teilweise Seitenansicht auf die Trennvorrichtung der Leiterplattentrenneinrichtung nach Figur 1;
- Figur 4: eine perspektivische Ansicht einer Mehrzahl von verschiedenen Halte- oder Stützelementen zur Verwendung bei dem Werkstückträger nach Figur 2;
- Figur 5: eine perspektivische Ansicht einer magazinartigen Aufnahme für Halte oder Stützelemente;
- Figur 6: eine perspektivische Ansicht eines Greifmittels zum Ergreifen und Positionieren eines Halte- oder Stützelements nach Figur 4;
- Figuren 7a, b, c: perspektivische teilweise Ansichten eines Werkstückträgers mit verschiedenen Halte- oder Stützelementen, wobei das Leiterplattensubstrat in 3 Positionen in Z-Richtung beim Aufsetzen auf den Werkstückträger dargestellt ist;
- Figuren 8a, b, c: Seitenansichten eines Ausschnitts aus Figuren 7a, b, c; und
- Figur 9: eine perspektivische Ansicht einer weiteren Ausführungsform eines magnetisch mit dem werkstückträger zusammenwirkenden Fußabschnitt mit mehreren Halte- oder Stützelementen.

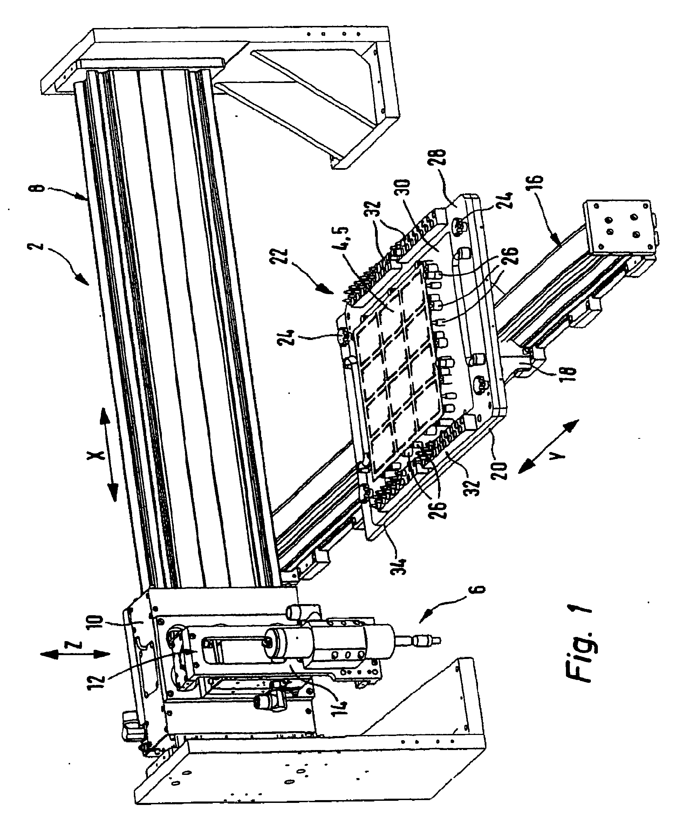

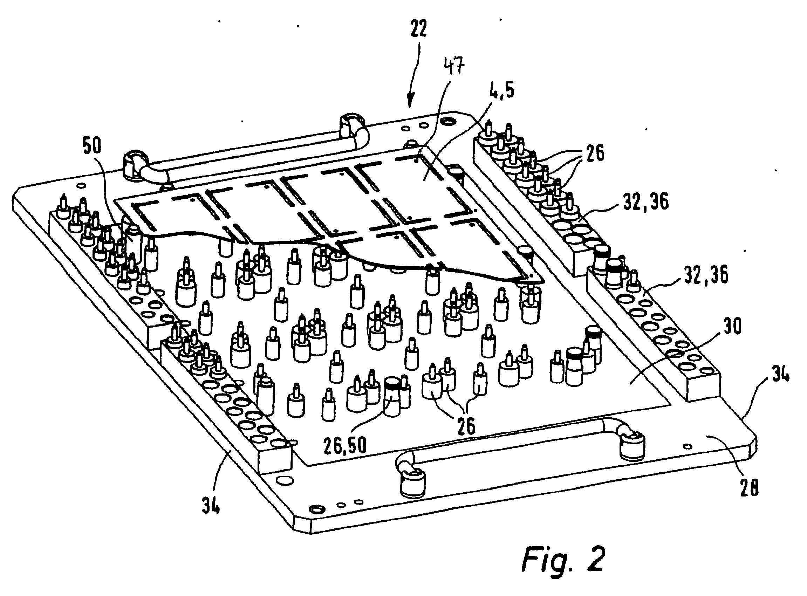

Figur 1 zeigt eine teilweise, perspektivische Darstellung einer insgesamt mit dem Bezugszeichen 2 bezeichneten Leiterplattentrenneinrichtung zum Vereinzeln von bestückten oder unbestückten Leiterplatten 5 aus einem Leiterplattensubstrat 4 mittels einer mechanisch wirkenden oder alternativ laserbasierten Trennvorrichtung 6. Von der Leiterplattentrenneinrichtung 2 sind keine weitergehenden Gehäusekomponenten und auch kein Maschinenbett dargestellt, sondern lediglich ein X-Achsenportal 8 mit einem Schlitten 10, an dem ein als Kurzhubachse ausgebildeter Z-Achsenantrieb 12 realisiert ist, der wiederum einen Schlitten 14 aufweist, welcher die Trennvorrichtung 6 trägt. Die Trennvorrichtung 6 ist im beispielhaft dargestellten Fall als Rotationsantrieb für ein spanabhebendes Werkzeug, wie zum Beispiel einen Fräser ausgebildet. Die an sich bekannten und daher nicht im einzelnen beschriebenen X- und Z-Achsenantriebe sind vorzugsweise von elektrischen Linearmotoren gebildet. Des weiteren umfasst die Leiterplattentrenneinrichtung eine Y-Achse bzw. einen Y-Achsenantrieb 16, die wiederum beispielhaft einen elektrischen Linearantrieb umfasst und an ihrem beweglichen Schlitten 18 eine Schnittstellenplatte 20 umfasst, gegen die ein insgesamt mit dem Bezugszeichen 22 bezeichneter Werkstückträger im beispielhaft dargestellten Fall mittels von Hand festziehbarer Schrauben 24 montierbar ist. Der Werkstückträger 22 ist auch in Figur 2 mit teilweise weggebrochenem Werkstück 4 dargestellt.

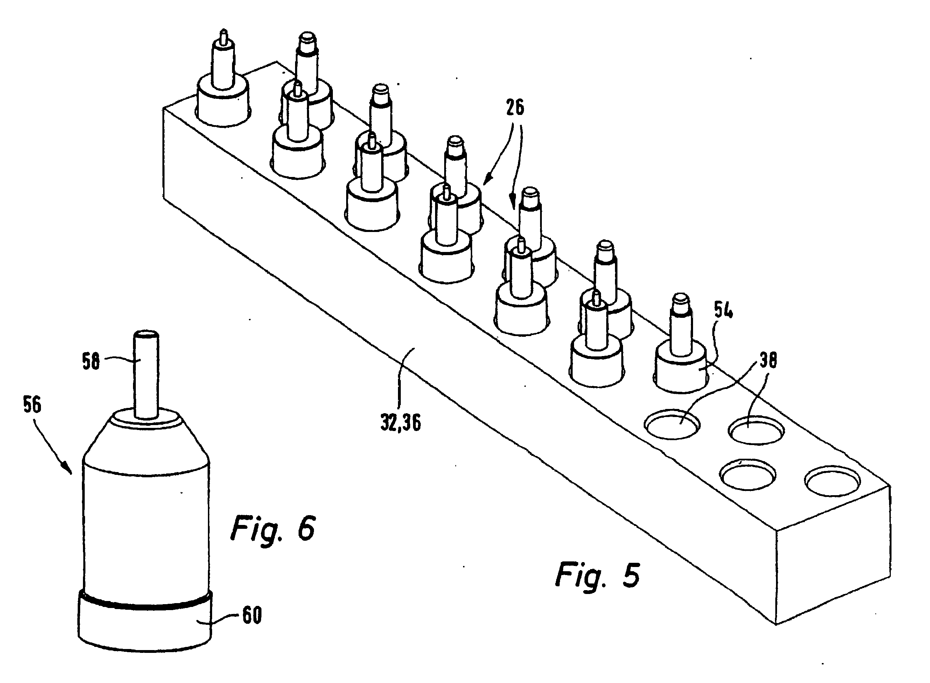

Der Werkstückträger 22 hat die Aufgabe, ein mehrere insbesondere bestückte Leiterplatten umfassendes Leiterplattensubstrat 4, in einer Bearbeitungsstation der Leiterplattentrenneinrichtung 2 zu halten. Dies geschieht über eine Vielzahl von Halte- oder Stützelementen 26, die magnetisch auf einer Grundbasis 28 des Werkstückträgers 22 positioniert und magnetisch daran gehalten sind. Hierfür umfasst ein im beispielhaften Fall rechteckförmiger Bereich 30 der Grundbasis 28 ein magnetisierbares, insbesondere eisenhaltiges Material. Die Vielzahl von Halte- oder Stützelementen 26 wird auf noch näher zu beschreibende Weise entsprechend dem zu trennenden Leiterplattensubstrat 4 auf der Grundbasis 28 positioniert. Diejenigen Halte- oder Stützelemente 26, die bei einer Bearbeitungsaufgabe nicht benötigt werden, befinden sich in magazinartigen Aufnahmen 32, die auf gegenüberliegenden Seiten entlang von Rändern 34 der Grundbasis 28 vorgesehen sind. Die magazinartigen Aufnahmen 32 sind von leistenartigen Teilen 36 gebildet, in welchen Ausnehmungen 38 zur Aufnahme der Halte- oder Stützelemente 26 ausgebildet sind. Diese Teile 36 sind in Figur 5 dargestellt.

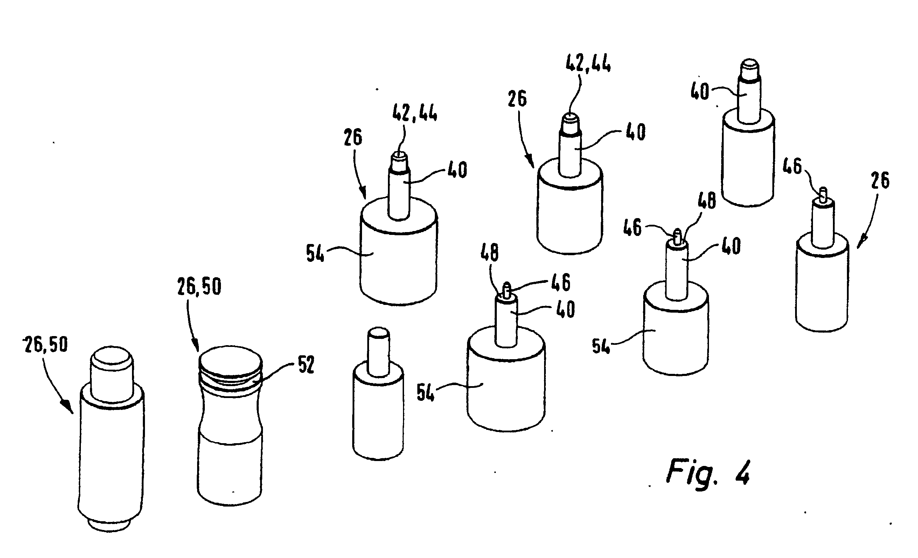

Figur 4 zeigt eine Mehrzahl verschiedener Halte- oder Stützelemente 26. Einige der Halte- oder Stützelemente 26 umfassen werkstückzugewandt einen stiftförmigen, im beispielhaft dargestellten Fall zylindrischen Abschnitt 40, mit dessen Stirnseite 42 die Halte- oder Stützelemente 26 gegen das Leiterplattensubstrat 4 anlegbar sind. Dabei kann der stiftförmige Abschnitt 40 eine plane Stirnseite 42 aufweisen, die eine ebene Auflage- oder Stützfläche 44 für das Leiterplattensubstrat 4 bildet, oder der betreffende stiftförmige Abschnitt 40 kann an seinem freien Ende ein verjüngtes Eingriffs- oder Zentriermittel 46 aufweisen, welches in Zentrierausnehmungen 47 in dem Leiterplattensubstrat 44 eingreifen kann. Um das verjüngte Eingriffs- oder Zentriermittel 46 herum ist vorzugsweise eine wiederum plane Anlagefläche 48 ausgebildet, gegen die das Leiterplattensubstrat 4 bzw. die vereinzelten Leiterplatten 5 mit einer Unterseite anlegbar ist.

Des weiteren zeigt Figur 4 Halte- oder Stützelemente 26 in Form von Seitenanschlagmitteln 50, welche seitlich gegen einen Rand 34 des Leiterplattensubstrats 4 anlegbar sind. Eines der Seitenanschlagmittel 50 weist eine parallel zur Ebene der Grundbasis 28 erstreckte schlitzförmige Ausnehmung 52 auf, in welche das Leiterplattensubstrat 4 mit einem Rand eingreifen kann, so wie dies aus Figur 2 ersichtlich ist.

Die Seitenanschlagmittel 50 können, wie die übrigen Halte- oder Stützelemente 26, magnetisch haftend mit der Grundbasis 28 zusammenwirken, oder sie können gewissermaßen mechanisch ortsfest mit der Grundbasis 28 verbunden sein, so dass sie von vornherein eine Referenzposition für das Leiterplattensubstrat 4 vorgeben.

Ein jeweiliges Halte- oder Stützelement 26 weist neben einem etwaigen stiftförmigen Abschnitt 40 einen mit der Grundbasis 28 magnetisch zusammenwirkenden Fußabschnitt 54 auf. In diesen Fußabschnitt 54 ist ein Permanentmagnet in nicht dargestellter Weise eingesetzt. Es wäre aber auch denkbar, dass der gesamte Fußabschnitt 54 von einem Permanentmagneten gebildet ist.

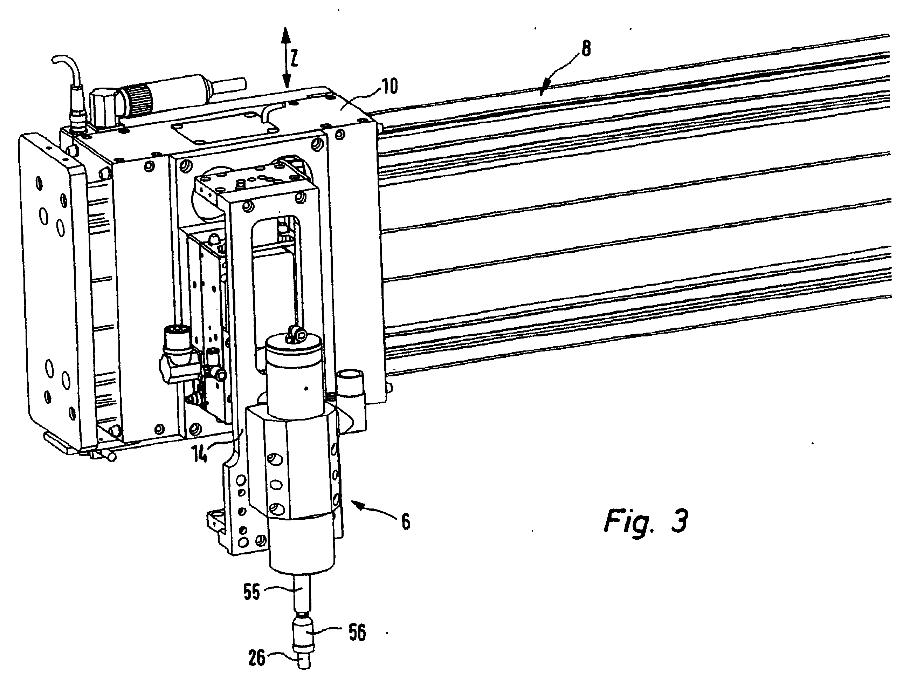

Figur 3 zeigt die Trennvorrichtung 6, die ein Spannfutter 55 für ein nicht dargestelltes Fräswerkzeug aufweist. In dieses Spannfutter 55 ist ein hülsenförmiges Greifmittel 56 eingespannt, mittels dessen ein jeweiliges Halte- oder Stützelement 26 aus der magazinartigen Aufnahme 32 entnehmbar ist. Hierfür wird das hülsenförmige Greifmittel 56 in Richtung der Z-Achse über das betreffende Halte- oder Stützelement 26 gestülpt. Das hülsenförmige Greifmittel 56 ist dabei so ausgebildet, dass es eine magnetische Haftverbindung mit dem betreffenden Halte- oder Stützelement 26 ausbildet. Zudem ist das Halte- oder Stützelement 26 in X/Y-Richtung im wesentlichen spielfrei in dem Greifmittel 56 gehalten. Das Greifmittel 56 ist perspektivisch in Figur 6 dargestellt. Man erkennt einen zylindrischen Einspannabschnitt 58 und ein magnetisch wirkendes, im beispielhaften Fall kreisringförmiges Segment 60.

Das kreisringförmige Segment 60 wirkt dabei magnetisch haftend mit dem Fußabschnitt 54 des Halte- oder Stützelements 26 zusammen, so dass dieses in Z-Richtung aus der magazinartigen Aufnahme 32 entnehmbar ist. Die Trennvorrichtung 6 kann dann insbesondere numerisch gesteuert ein jeweiliges Halte- oder Stützelement 26 aus der Aufnahme 32 zu einer vorbestimmten Position auf der Grundbasis 28 verbringen und dort in Z-Richtung positionieren. Beim Positionieren des Halte- oder Stützelements 26 auf dem Bereich 30 der Grundbasis 28 kommt es zu einer noch stärkeren magnetischen Anhaftung, so dass beim anschließenden Hochfahren des Greifmittels 56 das Halte- oder Stützelement 26 auf der Grundbasis 28 verbleibt.

Sämtliche Halte- oder Stützelemente 26 einschließlich der Seitenanschlagmittel 50 und des hülsenförmigen Greifmittels 56 können in einer magazinartigen Aufnahme 32 bei der Grundbasis 28 vorgehalten und dann je nach Anforderung unter Verwendung der numerisch programmierbaren und steuerbaren Lasertrenneinrichtung entnommen und nach einem vorgegebenen Bestückprogramm auf der Grundbasis 28 des Werkstückträgers 22 positioniert werden. Wie bereits angedeutet kann es sich als vorteilhaft erweisen, wenn die Seitenanschlagmittel 50, insbesondere diejenigen mit einer schlitzförmigen Ausnehmung, manuell auf der Grundbasis positioniert und fixiert werden.

Nach Ausführung des Bestückvorgangs kann das hülsenförmige Greifmittel 56 an einer vorbestimmten Position der magazinartigen Aufnahme 32 abgesetzt werden und durch ein Fräswerkzeug oder ein sonstiges Werkzeug ersetzt werden. Währenddessen kann der Werkstückträger 22 mit einem Leiterplattensubstrat 4 versehen werden, und - nachdem er wieder in die Bearbeitungsstation verfahren wurde - kann die Trennbearbeitung ausgeführt werden.

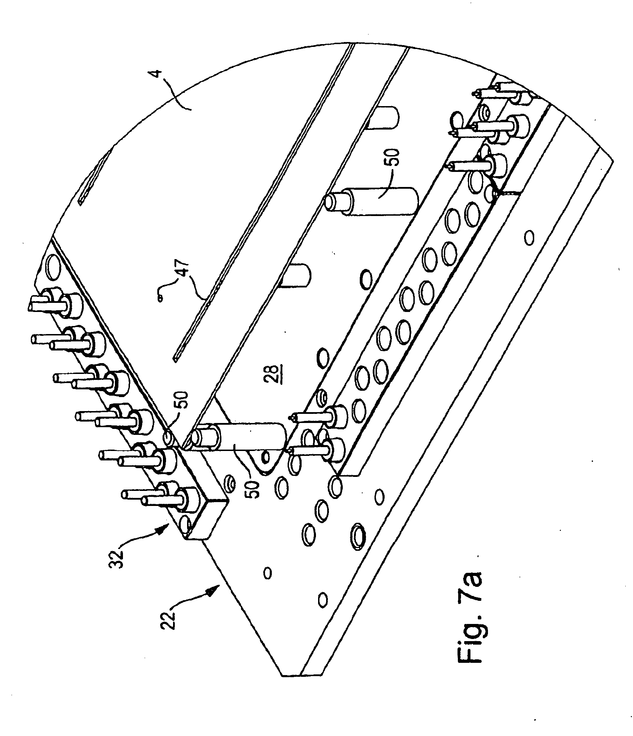

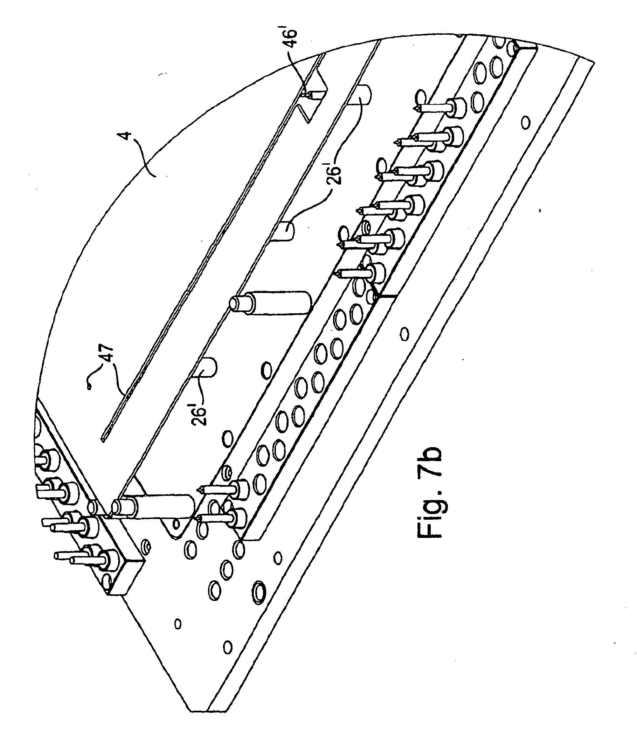

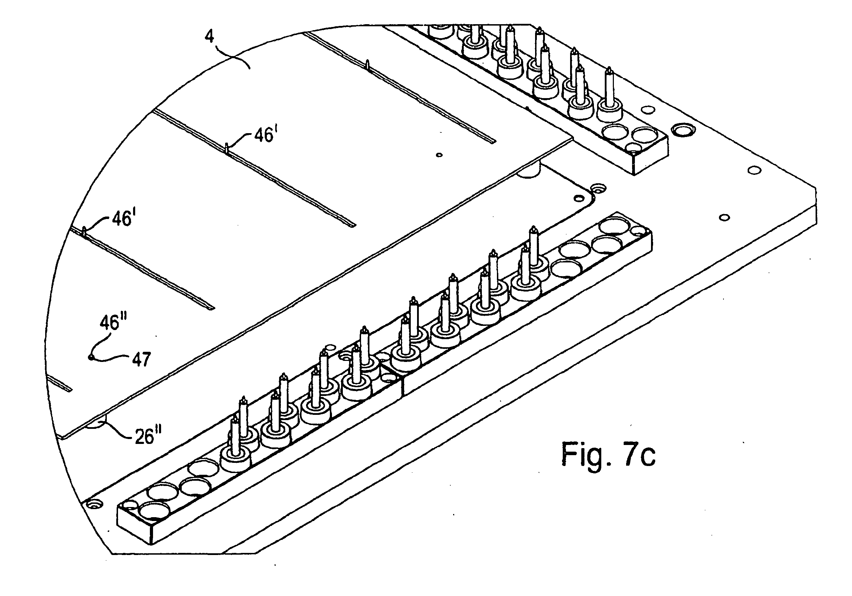

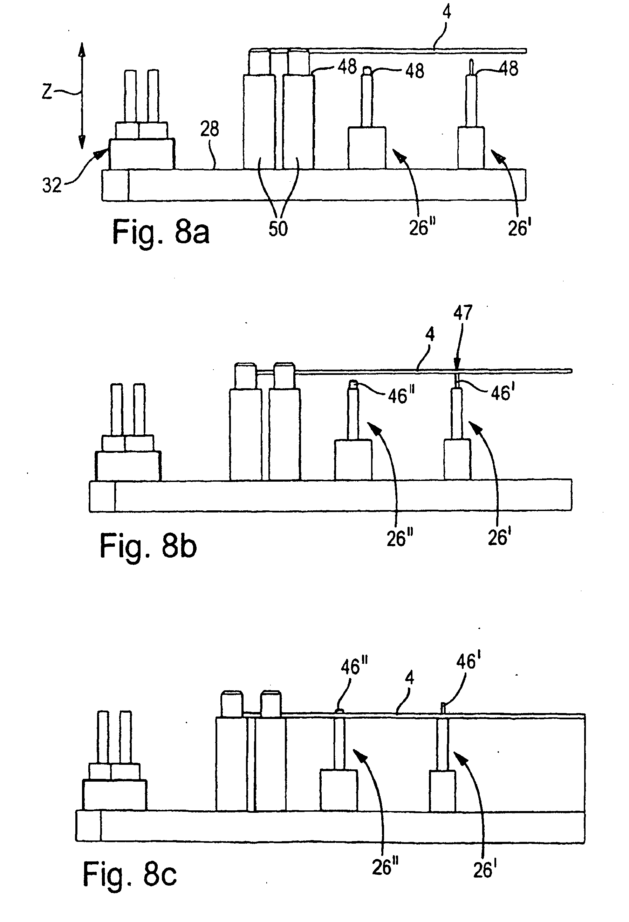

Anhand der Figuren 7a, b, c und 8a, b, c wird eine weitere vorteilhafte Ausführungsform der erfindungsgemäßen Leiterplattentrenneinrichtung beschrieben. Die Figuren zeigen perspektivische Teilansichten eines Werkstückträgers, wobei das Leiterplattensubstrat 4 in drei unterschiedlichen Positionen in Z-Richtung beim Aufsetzen auf den Werkstückträger 22 dargestellt ist. Figuren 8a, b und c verdeutlichen dies anhand von vergrößerten Seitenansichten eines Teils der Figuren 7a, b und c. Die Figuren 7 und 8 zeigen Halte- bzw. Stützelemente in Form von Seitenanschlagmitteln 50, die der Referenzierung bzw. groben Zentrierung des Leiterplattensubstrats 4 dienen. Solche Seitenanschlagmittel 50 sind im beispielhaft dargestellten Fall nur im Bereich zweier Seiten des Leiterplattensubstrats 4 vorgesehen. Sie sind wiederum beispielhaft nicht oder nicht ausschließlich magnetisch gegenüber einer Grundbasis 28 des Werkstückträgers 22 gehalten, sondern sie sind in darin vorgesehene Ausnehmungen eingesteckt. Die Seitenanschlagmittel 50 können somit auch manuell ortsgenau positioniert werden. Die Figur 8a zeigt die Position des Leiterplattensubstrats 4 in Z-Richtung. Man erkennt, dass beim Referenzieren des Leiterplattensubstrats 4 durch Anlegen an die Seitenanschlagmittel 50 ein Abstand zu den übrigen in Figur 8a dargestellten Halte- oder Stützelementen gegeben ist.

Beim Übergang von der in Figur 7a dargestellten Position des Leiterplattensubstrats 4 in die in Figur 7b bzw. Figur 8b dargestellte Position wird das Leiterplattensubstrat 4 in Z-Richtung weiter abgesenkt bis es in den Bereich erster Halte- oder Stützelemente 26' mit Eingriffs- oder Zentriermitteln 46' gelangt. Dabei greifen diese Eingriffs- oder Zentriermittel 46' in Eingriffs- oder Zentrierausnehmungen 47 in dem Leiterplattensubstrat 4 ein. Im beispielhaft dargestellten Fall sind diese Eingriffs- oder Zentrierausnehmungen 46' schlitzförmig ausgebildet. Dieser Eingriff dient also gewissermaßen einer weiteren Vorpositionierung des Leiterplattensubstrats 4 am Werkstückträger. In der in Figuren 7b und 8b dargestellten Situation befindet sich das Leiterplattensubstrat 4 in einem Abstand in Z-Richtung zu weiteren Halte- oder Stützelementen 26" und deren Eingriffs- oder Zentriermitteln 46".

Figuren 7c und 8c zeigen die schlussendliche bestimmungsgemäße Anordnung des Leiterplattensubstrats 4. Zur hochgenauen Fixierung und Anordnung des Leiterplattensubstrats 4 gelangen die vorerwähnten Eingriffs- oder Zentriermittel 46" der zweiten Halte- oder Stützelemente 26" in Eingriff mit exakt ausgebildeten Eingriffs- oder Zentrierausnehmungen 47 in dem Leiterplattensubstrat 4. Erst jetzt ist eine hochgenaue Feinpositionierung des Leiterplattensubstrats 4 auf dem Werkstückträger 22 erreicht. Das Leiterplattensubstrat 4 liegt flächenhaft auf jeweiligen ebenen Anlageflächen 48 (die in Figur 8a bezeichnet sind) auf. Des Weiteren können Halte- oder Stützelemente vorgesehen sein, die mit ihrer Stirnseite, also ohne Eingriffs- oder Zentriermittel, von unten gegen das Leiterplattensubstrat 4 anliegen und dieses stützen.

Durch Seitenanschlagmittel 50 und erste bzw. zweite Halte- oder Stützelemente 26' bzw. 26" der vorstehend beschriebenen Art lässt sich das Anordnen des Leiterplattensubstrats 4 auf dem Werkstückträger 22 sehr rasch bewerkstelligen, und zwar ohne dass zu Ungenauigkeiten führende mehrfache Verschiebebewegungen des Leiterplattensubstrats 4 gegenüber den Halte-oder Stützelementen ausgeführt werden müssen. Es wird gewissermaßen eine Vorreferenzierung, eine Vorpositionierung und schließlich eine Feinpositionierung durchgeführt, wobei mit jedem Schritt eine gewisse Zentrierung in Richtung auf die bestimmungsgemäße hochgenaue Position einhergeht.

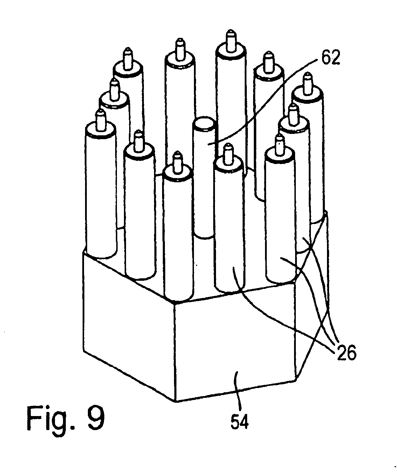

Figur 9 zeigt eine weitere Ausführungsform von Halte- oder Stützelementen, wobei auf einem Fußabschnitt 54 gleichzeitig mehrere Halte- oder Stützelemente 26 angeordnet sind, die somit einen wesentlich geringeren Abstand A voneinander aufweisen als die Abmessung des Fußabschnitts 54 in der Ebene der Grundbasis 28 des Werkstückträgers 22. Auf diese Weise können eng beieinanderliegende Stützpunkte für eine sehr kleine Leiterplatte realisiert werden. Beispielhaft in der Mitte des Fußabschnitts ist eine senkrecht emporstehendes stiftförmiges Mittel 62 zum automatisierten Ergreifen des Fußabschnitts 54 mit den mehreren Halte- oder Stützelementen 26 vorgesehen werden, der mit dem vorausgehend beschriebenen Greifmittel 56 zusammenwirken kann. Alternativ könnte dort eine Öffnung, Vertiefung oder Bohrung zum Zusammenwirken mit dem Greifmittel vorgesehen sein.

## Patentansprüche

1. Leiterplattentrenneinrichtung (2) zum Vereinzeln von insbesondere bestückten Leiterplatten (5) aus einem Leiterplattensubstrat (4), mit einer mechanisch wirkenden oder laserbasierten numerisch steuerbaren Trennvorrichtung (6) und mit einem Werkstückträger (22), wobei das Leiterplattensubstrat (4) und die hieraus im Zuge der Trennbearbeitung vereinzelten Leiterplatten (5) während der Trennbearbeitung auf dem Werkstückträger (22) gehalten ist/sind, **dadurch gekennzeichnet, dass** der Werkstückträger (22) eine Grundbasis (28) und magnetisch mit der Grundbasis (28) zusammenwirkende Halte- oder Stützelemente (26) für das Leiterplattensubstrat (4) umfasst, wobei ein Fußabschnitt (54) des jeweiligen Halte- oder Stützelements (26) magnetisch mit der Grundbasis (28) zusammenwirkt, dass der Werkstückträger (22) eine magazinartige Aufnahme (32) für eine Mehrzahl von Halte- oder Stützelementen (26) aufweist und die Trennvorrichtung (6) mit einem Greifmittel (56) ausgestattet ist, mittels dessen Halte- oder Stützelemente (26) aus der Aufnahme (32) entnehmbar und auf der Grundbasis (28) positionierbar sind, wobei die Entnahme und Positionierung der Halte- oder Stützelemente (26) numerisch gesteuert durchführbar ist, und dass die Trennvorrichtung (6) ein Spannfutter (55) für ein Werkzeug zur Trennbearbeitung umfasst, in welches das Greifmittel (56) zur Ausführung eines Bestückvorgangs des Werkstückträgers (22) einspannbar ist, und dass die Halte- oder Stützelemente werkstückzugewandt ein verjüngtes Eingriffs- oder Zentriermittel (46) aufweisen, mittels dessen sie in Eingriffs- oder Zentrierausnehmungen des Leiterplattensubstrats (4) eingreifen können, und dass das Greifmittel (56) eine Hülse umfasst, die über ein jeweiliges Halte- oder Stützelement (26) stülpbar ist, wobei das jeweilige Halte- oder Stützelement in der Hülse magnetisch fixierbar ist, so dass es greifbar und handhabbar ist.

2. Leiterplattentrenneinrichtung (2) nach Anspruch 1, **dadurch gekennzeichnet, dass** ein Permanentmagnet in das Halte- oder Stützelement (26) oder in den Fußabschnitt (54) des Halte- oder Stützelements (26) integriert ist.

3. Leiterplattentrenneinrichtung (2) nach Anspruch 1 oder 2, **dadurch gekennzeichnet, dass** die Grundbasis (28) aus Eisen gebildet ist oder ein eisenhaltiges und/oder magnetisches oder magnetisierbares Material umfasst.

4. Leiterplattentrenneinrichtung (2) nach einem oder mehreren der vorstehenden Ansprüche, **dadurch gekennzeichnet, dass** die magazinartige Aufnahme (32) auf der Grundbasis (28) angeordnet ist (B).

5. Leiterplattentrenneinrichtung (2) nach einem oder mehreren der vorstehenden Ansprüche, **dadurch gekennzeichnet, dass** Halte- oder Stützelemente (26) in Form von Seitenanschlagmitteln (50) zum Positionieren oder Referenzieren des Leiterplattensubstrats (4) am Werkstückträger (22) vorgesehen sind, die vorzugsweise ebenfalls magnetisch fixierbar sind und vorzugsweise geringfügig senkrecht zur Leiterplattenebene über das Leiterplattensubstrat (4) überstehen und so in der Ebene des Leiterplattensubstrats von außen seitlich gegen das Leiterplattensubstrat (4) anlegbar sind.

6. Leiterplattentrenneinrichtung (2) nach einem oder mehreren der vorstehenden Ansprüche, **gekennzeichnet durch** Seitenanschlagmittel (50), die eine parallel zur Ebene der Grundbasis (28) erstreckte Abstufung oder schlitzförmige Ausnehmung (52) aufweisen, in welche ein Rand des flächenhaften Leiterplattensubstrats (4) eingreifen kann und **dadurch** das Leiterplattensubstrat (4) in senkrechter Richtung zum Werkstückträger (22) fixierbar ist.

7. Leiterplattentrenneinrichtung (2) nach einem oder mehreren der vorstehenden Ansprüche, **dadurch gekennzeichnet, dass** zum Positionieren des Leiterplattensubstrats (4) wenigstens zwei erste Halte- oder Stützelemente (26') mit einem werkstückzugewandten verjüngten Eingriffs- oder Zentriermittel (46') und mehrere zweite Halte- oder Stützelemente (26") mit einem werkstückzugewandten verjüngten Eingriffs- oder Zentriermittel (26") vorgesehen sind und dass die Eingriffs- oder Zentriermittel (46') der ersten Halte- oder Stützelemente (26') in Z-Richtung länger vorstehen als die Eingriffs- oder Zentriermittel (26") der zweiten Halte- oder Stützelemente (26''), wobei die ersten Halte- oder Stützelemente (26') einer Vorpositionierung und die zweiten Halte- oder Stützelemente (26") einer schlussendlichen Feinpositionierung dienen.

8. Leiterplattentrenneinrichtung (2) nach einem oder mehreren der vorstehenden Ansprüche, **dadurch gekennzeichnet, dass** zum Referenzieren des Leiterplattensubstrats (4) am Werkstückträger (22) Halte- oder Stützelemente (26) in Form von Seitenanschlagmitteln (50) vorgesehen sind und zum anschließenden Positionieren des Leiterplattensubstrats (4) wenigstens zwei erste Halte- oder Stützelemente (26') mit einem werkstückzugewandten verjüngten Eingriffs- oder Zentriermittel (46') und mehrere zweite Halte- oder Stützelemente (26") mit einem werkstückzugewandten verjüngten Eingriffs- oder Zentriermittel (26") vorgesehen sind und dass die Eingriffs- oder Zentriermittel (46') der ersten Halte- oder Stützelemente (26') in Z-Richtung länger vorstehen als die Eingriffs- oder Zentriermittel (26") der zweiten Halte- oder Stützelemente (26"), wobei die ersten Halte- oder Stützelemente (26') einer Vorpositionierung und die zweiten Halte- oder Stützelemente (26") einer schlussendlichen Feinpositionierung dienen.

9. Leiterplattentrenneinrichtung (2) nach einem oder mehreren der vorstehenden Ansprüche, **gekennzeichnet durch** Halte- oder Stützelemente (26), welche einen mit der Grundbasis (28) magnetisch zusammenwirkenden Fußabschnitt (54) aufweisen, gegen den eine Mehrzahl verschiedener mit dem Leiterplattensubstrat zusammenwirkender Abschnitte anfügbar, insbesondere anschraubbar ist.

10. Leiterplattentrenneinrichtung (2) nach einem oder mehreren der vorstehenden Ansprüche, **dadurch gekennzeichnet, dass** auf einem Fußabschnitt (54) gleichzeitig mehrere Halte- oder Stützelemente (26) angeordnet sind, die somit einen geringeren Abstand voneinander aufweisen als die Abmessung des Fußabschnitts (54) in der Ebene der Grundbasis (28).

11. Leiterplattentrenneinrichtung (2) nach einem oder mehreren der vorstehenden Ansprüche, **dadurch gekennzeichnet, dass** in eine programmierbare Steuervorrichtung der Leiterplattentrenneinrichtung ein Bestückprogramm für die Entnahme und Positionierung der Halte- oder Stützelemente (26) eingebbar ist.

12. Leiterplattentrenneinrichtung (2) nach einem oder mehreren der vorstehenden Ansprüche, **dadurch gekennzeichnet, dass** die Trennvorrichtung (6) ein Spannfutter (55) für einen Fräser, umfasst.

13. Verfahren zum Betreiben einer Leiterplattentrenneinrichtung (2) nach einem oder mehreren der vorstehenden Ansprüche, wobei das Leiterplattensubstrat (4) und die hieraus im Zuge der Trennbearbeitung vereinzelten Leiterplatten (5) während der Trennbearbeitung auf dem Werkstückträger (22) gehalten ist/sind, **dadurch gekennzeichnet, dass** eine Grundbasis (28) des Werkstückträgers (22) in eine Bearbeitungsstation der Leiterplattentrenneinrichtung (2) gebracht wird und dass in dieser Bearbeitungsstation entsprechend einem numerischen Bestückungsprogramm unter Verwendung der Trennvorrichtung (6) die Halte- oder Stützelemente (26) auf der Grundbasis (28) angeordnet werden, dass dann ein Leiterplattensubstrat (4) auf die Halte- oder Stützelemente (26) aufgelegt und mittels Eingriffs- und Zentriermitteln (46) der Halte- oder Stützelemente (26) in die bestimmungsgemäße Position am Werkstückträger gebracht wird und dass dann unter Verwendung der Trennvorrichtung (6) die Trennbearbeitung ausgeführt wird.

14. Verfahren nach Anspruch 13, **dadurch gekennzeichnet, dass** das Leiterplattensubstrat unter Verwendung von ersten und zweiten Halte- oder Stützelementen mit in Z-Richtung verschieden langen Eingriffs- und Zentriermitteln zur Vorpositionierung und Feinpositionierung auf dem Werkstückträger angeordnet wird.

## Claims

1. A circuit board partition device (2) for separating circuit boards (5), in particular assembled circuit boards, from a circuit board substrate (4), having a mechanically acting or laser-based, numerically controllable partitioning apparatus (6) and having a workpiece holder (22), the circuit board substrate (4) and the circuit boards (5) separated from it in the course of the partitioning process being held on the workpiece holder (22) during the partitioning process, **characterized in that** the workpiece holder (22) includes a base (28) and retention or support elements (26) for the circuit board substrate (4) which cooperate magnetically with the base (28), and a foot portion (54) of the respective retention or support element (26) cooperates magnetically with the base (28); that the workpiece holder (22) has a magazine-like receptacle (32) for a plurality of retention or support elements (26), and the partitioning apparatus (6) is capable of being equipped with a gripping means (56), by means of which retention or support elements (26) are removable from the receptacle (32) and positionable on the base (28), and the removal and positioning of the retention or support elements (26) is capable of being carried out in numerically controlled fashion; and that the partitioning apparatus (6) includes a chuck (55) for a tool for the partitioning process, into which the gripping means (56) can be fastened for performing an assembly operation of the workpiece holder (22) and that the retention or support elements, toward the workpieces, have a tapered engagement or centering means (46), by means of which they can engage engagement or centering recesses of the circuit board substrate (4) and that the gripping means (56) includes a sleeve, which can be slipped onto a respective retention or support element (26), wherein the respective retention or support element is fixable in the sleeve magnetically, so that it is capable of being grasped and manipulated.

2. The circuit board partition device (2) according to claim 1, **characterized in that** a permanent magnet is integrated with the retention or support element (26) or with the foot portion (54) of the retention or support element (26).

3. The circuit board partition device (2) according to claim 1 or 2, **characterized in that** the base (28) is formed of iron or includes an iron-containing or magnetic or magnetizable material.

4. The circuit board partition device (2) according to one or more of the foregoing claims, **characterized in that** the magazine-like receptacle (32) is disposed (B) on the base (28).

5. The circuit board partition device (2) according to one or more of the foregoing claims, **characterized in that** retention or support elements (26) in the form of lateral stop means (50) for positioning or referencing the circuit board substrate (4) on the workpiece (22) are provided, which are preferably likewise magnetically fixable and preferably project perpendicularly to the plane of the circuit board slightly past the circuit board substrate (4) and thus are capable of being placed in the plane of the circuit board substrate from outside laterally against the circuit board substrate (4).

6. The circuit board partition device (2) according to one or more of the foregoing claims, **characterized by** lateral stop means (50), which have a graduation or slotlike recess (52) extending parallel to the plane of the base (28), which recess can be engaged by an edge of the plane circuit board substrate (4), and as a result, the circuit board substrate (4) is fixable in the direction perpendicular to the workpiece holder (22).

7. The circuit board partition device (2) according to one or more of the foregoing claims, **characterized in that** for positioning the circuit board substrate (4), at least two first retention or support elements (26') are provided with an engagement or centering means (46') that is tapered toward the workpieces, and a plurality of second retention or support elements (26") are provided with engagement or centering means (46") that are tapered toward the workpieces; and that the engagement or centering means (46') of the first retention or support elements (26') protrude to a greater length in the Z direction than the engagement or centering means (46") of the second retention or support elements (26"), and the first retention or support elements (26') serve the purpose of prepositioning, and the second retention or support elements (26") serve the purpose of final fine positioning.

8. The circuit board partition device (2) according to one or more of the foregoing claims, **characterized in that** for referencing a circuit board substrate (4) on the workpiece holder (22), retention or support elements (26) in the form of lateral stop means (50) are provided, and for then ensuing positioning of the circuit board substrate (4), at least two first retention or support elements (26') are provided with an engagement or centering means (46') that is tapered toward the workpieces, and a plurality of second retention or support elements (26") are provided with an engagement or centering means (46") that is tapered toward the workpieces; and that the engagement or centering means (46') of the first retention or support elements (26') protrude to a greater length in the Z direction than the engagement or centering means (46") of the second retention or support elements (26"), and the first retention or support elements (26') serve the purpose of prepositioning, and the second retention or support elements (26") serve the purpose of final fine positioning.

9. The circuit board partition device (2) according to one or more of the foregoing claims, **characterized by** retention or support elements (26) which have a foot portion (54) cooperating magnetically with the base (28), against which foot portion a plurality of portions cooperating with the circuit board substrate are capable of being joined, in particular of being screwed on.

10. The circuit board partition device (2) according to one or more of the foregoing claims, **characterized in that** on a foot portion (54), a plurality of retention or support elements (26) are disposed simultaneously, which thus have a spacing from one another that is less than the size of the foot portion (54) in the plane of the base (28).

11. The circuit board partition device (2) according to one or more of the foregoing claims, **characterized in that** an assembly program for the removal and positioning of the retention or support elements (26) can be input into a programmable controller of the circuit board partition device.

12. The circuit board partition device (2) according to one or more of the foregoing claims, **characterized in that** the partitioning apparatus (6) includes a chuck (55) for a milling cutter.

13. A method for operating a circuit board partition device (2) according to one or more of the foregoing claims, in which the circuit board substrate (4) and the circuit boards (5) separated from it in the course of the partitioning process are held on the workpiece holder (22) during the partitioning process, **characterized in that** a base (28) of the workpiece holder (22) is brought into a processing station of the circuit board partition device (2); and that in this processing station, the retention or support elements (26) are disposed on the base (28) in accordance with a numerical pick-and-place program using the partitioning apparatus (6); that then a circuit board substrate (4) is placed on the retention or support elements (26) and brought into the intended position on the workpiece holder by means of engagement or centering means (46) of the retention or support elements (26); and that then, using the partitioning apparatus (6), the partitioning process is performed.

14. The method according to claim 13, **characterized in that** the circuit board substrate is disposed on the workpiece holder using first and second retention or support elements with engagement or centering means of various lengths in the Z direction for prepositioning and fine positioning.

## Revendications

1. Dispositif de séparation de cartes de circuits imprimés (2) pour isoler des cartes de circuits imprimés (5), en particulier équipées, dans un substrat de cartes de circuits imprimés (4), comprenant un dispositif de séparation (6) agissant mécaniquement ou basé sur laser et apte à être commandé de façon numérique, ainsi qu'un porte-pièce (22), ledit substrat de cartes de circuits imprimés (4) et les cartes de circuits imprimés (5) isolées dans celui-ci au cours de l'usinage de séparation étant maintenu(s) sur ledit porte-pièce (22) durant l'usinage de séparation, **caractérisé par le fait que** ledit porte-pièce (22) comprend une base de fond (28) et des éléments de maintien ou de support (26) pour ledit substrat de cartes de circuits imprimés (4), qui coopèrent de façon magnétique avec ladite base de fond (28), une section de pied (54) de l'élément respectif de maintien ou de support (26) agissant magnétiquement de concert avec ladite base de fond (28), que ledit porte-pièce (22) comprend un logement (32) de type magasin pour une pluralité d'éléments de maintien ou de support (26) et que ledit dispositif de séparation (6) peut être équipé d'un élément de préhension (56) par le biais duquel des éléments de maintien ou de support (26) peuvent être retirés dudit logement (32) et être positionnés sur ladite base de fond (28), l'action de retirer et de positionner les éléments de maintien ou de support (26) pouvant être effectuée à commande numérique, et que le dispositif de séparation (6) comprend un mandrin de serrage (55) pour un outil d'usinage de séparation, dans lequel peut être serré le moyen de préhension (56) pour effectuer une opération d'équipement du porte-pièce (22), et que lesdits éléments de maintien ou de support présentent un moyen rétréci d'engagement ou de centrage (46) qui est tourné vers la pièce et au moyen duquel ils peuvent s'engager dans des évidements d'engagement ou de centrage dudit substrat de cartes de circuits imprimés (4) et que ledit moyen de préhension (56) comprend une douille qui peut être enfoncée sur un élément respectif de maintien ou de support (26), ledit élément respectif de maintien ou de support pouvant être fixé magnétiquement dans ladite douille de sorte qu'il puisse être prise et manipulé.

2. Dispositif de séparation de cartes de circuits imprimés (2) selon la revendication 1, **caractérisé par le fait qu'**un aimant permanent est intégré à l'élément de maintien ou de support (26) ou à ladite section de pied (54) de l'élément de maintien ou de support (26).

3. Dispositif de séparation de cartes de circuits imprimés (2) selon la revendication 1 ou 2, **caractérisé par le fait que** ladite base de fond (28) est réalisée en fer ou comprend un matériau ferreux et/ou magnétique ou apte à être aimanté.

4. Dispositif de séparation de cartes de circuits imprimés (2) selon l'une ou plusieurs des revendications précédentes, **caractérisé par le fait que** ledit logement (32) de type magasin est disposé (B) sur ladite base de fond (28).

5. Dispositif de séparation de cartes de circuits imprimés (2) selon l'une ou plusieurs des revendications précédentes, **caractérisé par le fait que** des éléments de maintien ou de support (26) sous forme de moyens de butée latéraux (50) sont prévus pour positionner ou référencer le substrat de cartes de circuits imprimés (4) sur ledit porte-pièce (22), qui, de préférence, peuvent être fixés, eux aussi, de façon magnétique et qui, de préférence, dépassent légèrement le substrat de cartes de circuits imprimés (4), perpendiculairement au plan de carte de circuits imprimés et peuvent être appliqués ainsi de l'extérieur latéralement contre le substrat de cartes de circuits imprimés (4), dans le plan du substrat de cartes de circuits imprimés.

6. Dispositif de séparation de cartes de circuits imprimés (2) selon l'une ou plusieurs des revendications précédentes, **caractérisé par** des moyens de butée latéraux (50) qui présentent un gradin ou évidement en forme de fente (52) qui s'étend parallèlement au plan de la base de fond (28) et dans lequel peut s'engager un bord dudit substrat en nappe de cartes de circuits imprimés (4) ce par quoi le substrat de cartes de circuits imprimés (4) peut être fixé dans la direction perpendiculaire au porte-pièce (22).

7. Dispositif de séparation de cartes de circuits imprimés (2) selon l'une ou plusieurs des revendications précédentes, **caractérisé par le fait que**, pour le positionnement dudit substrat de cartes de circuits imprimés (4), on prévoit au moins deux premiers éléments de maintien ou de support (26') comprenant un moyen rétréci d'engagement ou de centrage (46') qui est tourné vers la pièce ainsi qu'une pluralité de deuxièmes éléments de maintien ou de support (26") comprenant un moyen rétréci d'engagement ou de centrage (46") qui est tourné vers la pièce, et que lesdits moyens d'engagement ou de centrage (46') des premiers éléments de maintien ou de support (26') projettent d'une longueur plus importante dans la direction Z que les moyens d'engagement ou de centrage (46") des deuxièmes éléments de maintien ou de support (26"), lesdits premiers éléments de maintien ou de support (26') servant à un pré-positionnement et lesdits deuxièmes éléments de maintien ou de support (26") servant à un positionnement final de précision.

8. Dispositif de séparation de cartes de circuits imprimés (2) selon l'une ou plusieurs des revendications précédentes, **caractérisé par le fait que**, pour référencer le substrat de cartes de circuits imprimés (4) sur ledit porte-pièce (22), on prévoit des éléments de maintien ou de support (26) sous forme de moyens de butée latéraux (50) et que, pour le positionnement subséquent du substrat de cartes de circuits imprimés (4), on prévoit au moins deux premiers éléments de maintien ou de support (26') comprenant un moyen rétréci d'engagement ou de centrage (46') qui est tourné vers la pièce ainsi qu'une pluralité de deuxièmes éléments de maintien ou de support (26") comprenant un moyen rétréci d'engagement ou de centrage (46") qui est tourné vers la pièce, et que lesdits moyens d'engagement ou de centrage (46') des premiers éléments de maintien ou de support (26') projettent d'une longueur plus importante dans la direction Z que les moyens d'engagement ou de centrage (46") des deuxièmes éléments de maintien ou de support (26"), lesdits premiers éléments de maintien ou de support (26') servant à un pré-positionnement et lesdits deuxièmes éléments de maintien ou de support (26") servant à un positionnement final de précision.

9. Dispositif de séparation de cartes de circuits imprimés (2) selon l'une ou plusieurs des revendications précédentes, **caractérisé par** des éléments de maintien ou de support (26) qui présentent une section de pied (54) qui coopère de façon magnétique avec ladite base de fond (28) et contre laquelle peut être rapportée, en particulier vissée, une pluralité de sections différentes coopérant avec ledit substrat de cartes de circuits imprimés.

10. Dispositif de séparation de cartes de circuits imprimés (2) selon l'une ou plusieurs des revendications précédentes, **caractérisé par le fait que** sur une section de pied (54) sont disposés en même temps plusieurs éléments de maintien ou de support (26) qui, ainsi, présentent une distance entre eux plus faible que la dimension de la section de pied (54) dans le plan de ladite base de fond (28).

11. Dispositif de séparation de cartes de circuits imprimés (2) selon l'une ou plusieurs des revendications précédentes, **caractérisé par le fait que** l'on peut introduire dans un dispositif programmable de commande du dispositif de séparation de cartes de circuits imprimés un programme d'équipement pour la prise et le positionnement des éléments de maintien ou de support (26).

12. Dispositif de séparation de cartes de circuits imprimés (2) selon l'une ou plusieurs des revendications précédentes, **caractérisé par le fait que** le dispositif de séparation (6) comprend un mandrin de serrage (55) pour une fraise.

13. Procédé pour l'opération d'un dispositif de séparation de cartes de circuits imprimés (2) selon l'une ou plusieurs des revendications précédentes, ledit substrat de cartes de circuits imprimés (4) et les cartes de circuits imprimés (5) isolées dans celui-ci au cours de l'usinage de séparation étant maintenu(s) sur ledit porte-pièce (22) durant l'usinage de séparation, **caractérisé par le fait qu'**une base de fond (28) du porte-pièce (22) est amenée dans un poste d'usinage dudit dispositif de séparation de cartes de circuits imprimés (2) et que, dans ce poste d'usinage, les éléments de maintien ou de support (26) sont disposés sur ladite base de fond (28) selon un programme numérique d'équipement, en utilisant ledit dispositif de séparation (6), que, ensuite, un substrat de cartes de circuits imprimés (4) est posé sur les éléments de maintien ou de support (26) et est mis dans la position conforme sur le porte-pièce, par le biais de moyens d'engagement et de centrage (46) des éléments de maintien ou de support (26), et que, ensuite, l'usinage de séparation est effectué en utilisant ledit dispositif de séparation (6).

14. Procédé selon la revendication 13, **caractérisé par le fait que** ledit substrat de cartes de circuits imprimés est disposé sur le porte-pièce en utilisant des premiers et deuxièmes éléments de maintien ou de support comprenant des moyens d'engagement et de centrage de longueur différente dans la direction Z et servant au pré-positionnement et au positionnement de précision.
